# EUROPÄISCHE PATENTSCHRIFT

(11) **EP 2 581 225 B1**
(45) Veröffentlichungstag und Bekanntmachung des Hinweises auf die Patenterteilung: **14.09.2016**
(21) Anmeldenummer: 12187741.9
(22) Anmeldetag: 09.10.2012
(51) Int. Cl.: B32B 27/20, B32B 27/34, H01L 31/048

(54) **Rückfolie für Photovoltaikmodule mit verbesserter Pigmentdispergierung**
Backing film for photovoltaic modules with improved pigment dispersion
Film barrière pour module photovoltaïque avec amélioration de la dispersion de pigment

(30) Priorität: 14.10.2011 DE 102011084520
(43) Veröffentlichungstag der Anmeldung: 17.04.2013
(73) Patentinhaber: Evonik Degussa GmbH, 45128 Essen (DE)
(72) Erfinder: Pawlik, Andreas, Dr., 45657 Recklinghausen (DE); Wielpütz, Martin, Dr., 48308 Senden (DE); Beyer, Michael, 46348 Raesfeld (DE)

(56) Entgegenhaltungen:
- WO-A1-2008/138022
- WO-A1-2011/066595
- DE-A1-102008 044 225

## Beschreibung

Die Erfindung betrifft eine mehrschichtige Folie als Rückabdeckung für polyamidhaltige Solarmodule mit verbesserter Pigment- bzw. Füllstoffdispergierung.

Solarmodule, häufig auch als photovoltaische Module bezeichnet, dienen zur elektrischen Energieerzeugung aus Sonnenlicht und bestehen aus einem Laminat, welches als Kernschicht ein Solarzellensystem enthält. Diese Kernschicht ist mit Einkapselungsmaterialien umhüllt, die als Schutz gegen mechanische und witterungsbedingte Einflüsse dienen.

Die aktive Solarzelle befindet sich hierbei zwischen einer Frontabdeckung und einer Rückabdeckung. Die Frontabdeckung ist lichtdurchlässig und besteht im Regelfall aus Glas; sie ist mittels einer Haftvermittlerschicht, die häufig aus einem EthylenVinylacetat-Copolymeren besteht, mit der die Solarzelle enthaltenden Schicht verbunden. Die Rückabdeckung garantiert elektrische Abschirmung und dient als Schutz gegen Witterungseinflüsse, wie UV-Licht, und als Feuchtigkeitsbarriere.

Für die Rückabdeckung werden zur Zeit standardmäßig Folienverbunde aus Fluorpolymerfolien und Polyester verwendet. Die Fluorpolymerfolie an der Außenseite garantiert dabei die Witterungsbeständigkeit, die Polyesterfolie die mechanische Stabilität und die gewünschten elektrischen Isolationseigenschaften. Eine weitere Fluorpolymerfolie an der Innenseite dient zur Anbindung an die Siegelschicht des Solarzellensystems. Allerdings weisen derartige Fluorpolymerfolien nur eine geringe Haftung zur Siegelschicht auf, die als Einbettungsmaterial für die Solarzellen selbst verwendet wird. Darüber hinaus trägt die Fluorpolymerfolie nur in untergeordnetem Maß zur elektrischen Isolierung bei, woraus die Notwendigkeit der Verwendung einer vergleichsweise dicken Polyesterfolie resultiert.

In der WO 2008138022 wird daher vorgeschlagen, bei derartigen Verbunden die beiden Fluorpolymerfolien durch Folien aus Polyamid 12 (PA12) zu ersetzen. In einer Weiterbildung hiervon wird in der WO 2011066595 vorgeschlagen, dass die der Solarzelle zugewandte Thermoplastschicht einen Licht reflektierenden Füllstoff wie Titandioxid enthält, während die der Solarzelle abgewandte Thermoplastschicht einen zweiten Füllstoff, wie Glasfasern, Wollastonit oder Glimmer enthält, der eine höhere Wärmeleitfähigkeit dieser Schicht bewirkt. Beispielhafte Thermoplaste entstammen der Gruppe der Polyamide, Polyester oder Blends aus Polyamid und Polyolefin. Explizit genannt werden PA11, PA12 und PA1010 sowie deren Blends mit Polyolefinen.

In derartigen Photovoltaikmodulen kommt der Verteilung des Licht reflektierenden Füllstoffs besondere Bedeutung zu. So erhöht sich der Reflektionsgrad und damit die Stromausbeute der Solarzelle mit zunehmendem Dispersionsgrad. Darüber hinaus beeinflusst die Verteilungsgüte gleichzeitig die Oberflächenqualität der Rückfolie. Ausnehmend wichtig ist dies in der der eigentlichen Solarzelle zugewandten und in der nach außen sichtbaren, in der Regel rein polyamidbasierten Schicht der Rückabdeckung, da hier wegen der geringen Schichtdicken Pigmentagglomerate besonders augenfällig werden.

Die Aufgabe der Erfindung ist demzufolge, in den beiden äußeren Schichten der Rückfolie von Photovoltaikmodulen eine verbesserte Pigment- bzw. Füllstoffdispergierung zu erzielen.

Überraschend wurde gefunden, dass diese Aufgabe durch den Einsatz von Polyamidelastomeren vom Typ Polyetheresteramid oder Polyetheramid gelöst werden kann.

Gegenstand der Erfindung ist daher eine Folie, die folgende Schichten enthält:
a) Eine erste Außenschicht aus einer Formmasse, die
   I. einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, sowie
   II. einen Licht reflektierenden Füllstoffanteil von 1 bis 65 Gew.-%, bevorzugt von 2 bis 60 Gew.-%, besonders bevorzugt von 3 bis 55 Gew.-%, insbesondere bevorzugt von 4 bis 50 Gew.-% und ganz besonders bevorzugt von 5 bis 45 Gew.-% enthält,
b) optional eine Mittelschicht aus einer thermoplastischen Formmasse sowie
c) eine zweite Außenschicht aus einer Formmasse, die
   I. einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-% und
   II. einen Füllstoffanteil von 1 bis 65 Gew.-%, bevorzugt von 2 bis 60 Gew.-%, besonders bevorzugt von 3 bis 55 Gew.-%, insbesondere bevorzugt von 4 bis 50 Gew.-% und ganz besonders bevorzugt von 5 bis 45 Gew.-% besitzt,
wobei die Prozentangaben jeweils auf die gesamte Formmasse bezogen sind und wobei eine Modifizierung des Folienverbundes dadurch erfolgt, dass in der Formmasse der Schicht gemäß a) und/oder in der Formmasse der Schicht gemäß c) ein Polyamidelastomer, ausgewählt aus Polyetheresteramid und Polyetheramid, als Polyamidkomponente eingesetzt wird derart, dass die Formmasse der Schicht gemäß a) und/oder die Formmasse der Schicht gemäß c) 1 bis 25 Gew.-%, bevorzugt 2 bis 20 Gew.-% und besonders bevorzugt 4 bis 20 Gew.-% an Polyamidelastomer enthält.

Vorzugsweise folgen hierbei die Schichten gemäß a), b) und c) direkt aufeinander. Weiterhin ist bevorzugt, dass sowohl die Schicht gemäß a) als auch die Schicht gemäß c) das Polyamidelastomer enthält. In machen Fällen kann darüber hinaus zur Verbesserung der Schichtenhaftung zwischen den Schichten gemäß a) und b) und/oder zwischen den Schichten gemäß b) und c) eine Haftvermittlerschicht angebracht sein.

Das Polyamid kann ein teilkristallines Polyamid sein wie beispielsweise PA6, PA66, PA610, PA612, PA10, PA810, PA106, PA1010, PA11, PA1011, PA1012, PA1210; PA1212, PA814, PA1014, PA618, PA512, PA613, PA813, PA914, PA1015, PA11, PA12 oder ein teilaromatisches Polyamid, ein sogenanntes Polyphthalamid (PPA). (Die Kennzeichnung der Polyamide entspricht internationaler Norm, wobei die erste(n) Ziffer(n) die C-Atomzahl des Ausgangsdiamins und die letzte(n) Ziffer(n) die C-Atomzahl der Dicarbonsäure angeben. Wird nur eine Zahl genannt, so bedeutet dies, dass von einer α,ω-Aminocarbonsäure bzw. von dem davon abgeleiteten Lactam ausgegangen worden ist; im übrigen sei verwiesen auf H. Domininghaus, Die Kunststoffe und ihre Eigenschaften, Seiten 272 ff., VDI-Verlag, 1976.) Geeignete PPAs sind beispielsweise PA66/6T, PA6/6T, PA6T/MPMDT (MPMD steht für 2-Methylpentamethylendiamin), PA9T, PA10T, PA11T, PA12T, PA14T sowie Copolykondensate dieser letzten Typen mit einem aliphatischen Diamin und einer aliphatischen Dicarbonsäure oder mit einer ω-Aminocarbonsäure bzw. einem Lactam. Teilkristalline Polyamide besitzen eine Schmelzenthalpie von mehr als 25 J/g, gemessen mit der DSC-Methode gemäß ISO 11357 beim 2. Aufheizen und Integration des Schmelzpeaks.

Das Polyamid kann aber auch ein semikristallines Polyamid sein. Semikristalline Polyamide besitzen eine Schmelzenthalpie von 4 bis 25 J/g, gemessen mit der DSC-Methode gemäß ISO 11357 beim 2. Aufheizen und Integration des Schmelzpeaks. Beispiele für geeignete semikristalline Polyamide sind
- Das Polyamid aus 1,10-Decandisäure oder 1,12-Dodecandisäure und 4,4'-Diaminodicyclohexylmethan (PA PACM10 und PA PACM12), ausgehend von einem 4,4'-Diaminodicyclohexylmethan mit einem trans,trans-Isomerenanteil von 35 bis 65 %;
- Copolymere auf Basis der obengenannten teilkristallinen Polyamide; sowie
- Blends aus den obengenannten teilkristallinen Polyamiden und einem damit verträglichen amorphen Polyamid.

Das Polyamid kann auch ein amorphes Polyamid sein. Amorphe Polyamide besitzen eine Schmelzenthalpie von weniger als 4 J/g, gemessen mit der DSC-Methode gemäß ISO 11357 beim 2. Aufheizen und Integration des Schmelzpeaks. Beispiele für amorphe Polyamide sind:
- das Polyamid aus Terephthalsäure und/oder Isophthalsäure und dem Isomerengemisch aus 2.2.4- und 2.4.4-Trimethylhexamethylendiamin,
- das Polyamid aus Isophthalsäure und 1.6-Hexamethylendiamin,
- das Copolyamid aus einem Gemisch aus Terephthalsäure/Isophthalsäure und 1.6-Hexamethylendiamin, gegebenenfalls in Mischung mit 4.4'-Diaminodicyclohexylmethan,
- das Copolyamid aus Terephthalsäure und/oder Isophthalsäure, 3.3'-Dimethyl-4.4'-diaminodicyclohexylmethan und Laurinlactam oder Caprolactam,
- das (Co)Polyamid aus 1.12-Dodecandisäure oder Sebacinsäure, 3.3'-Dimethyl-4.4'-diaminodicyclohexylmethan und gegebenenfalls Laurinlactam oder Caprolactam,
- das Copolyamid aus Isophthalsäure, 4.4'-Diaminodicyclohexylmethan und Laurinlactam oder Caprolactam,
- das Polyamid aus 1.12-Dodecandisäure und 4.4'-Diaminodicyclohexylmethan (bei niedrigem trans,trans-Isomerenanteil),
- das (Co)Polyamid aus Terephthalsäure und/oder Isophthalsäure sowie einem alkylsubstituierten Bis(4-aminocyclohexyl)methan-Homologen, gegebenenfalls in Mischung mit Hexamethylendiamin,
- das Copolyamid aus Bis(4-amino-3-methyl-5-ethyl-cyclohexyl)methan, gegebenenfalls zusammen mit einem weiteren Diamin, sowie Isophthalsäure, gegebenenfalls zusammen mit einer weiteren Dicarbonsäure,
- das Copolyamid aus einer Mischung von m-Xylylendiamin und einem weiteren Diamin, z. B. Hexamethylendiamin, sowie Isophthalsäure, gegebenenfalls zusammen mit einer weiteren Dicarbonsäure wie z. B. Terephthalsäure und/oder 2,6-Naphthalindicarbonsäure,
- das Copolyamid aus einer Mischung von Bis(4-amino-cyclohexyl)methan und Bis-(4-amino-3-methyl-cyclohexyl)methan sowie aliphatischen Dicarbonsäuren mit 8 bis 14 C-Atomen, sowie
- Polyamide oder Copolyamide aus einer Mischung, die 1.14-Tetradecandisäure sowie ein aromatisches, arylaliphatisches oder cycloaliphatisches Diamin enthält.

Diese Beispiele können durch Hinzunahme weiterer Komponenten (z. B. Caprolactam, Laurinlactam oder Diamin/Dicarbonsäure-Kombinationen) oder durch teilweisen oder vollständigen Ersatz von Ausgangskomponenten durch andere Komponenten weitestgehend variiert werden.

Polyetheresteramide sind z. B. aus der DE-A-25 23 991 und der DE-A-27 12 987 bekannt; sie enthalten als Comonomer ein Polyetherdiol. Polyetheramide sind beispielsweise aus der DE-A- 30 06 961 bekannt; sie enthalten als Comonomer ein Polyetherdiamin.

Beim Polyetherdiol bzw. dem Polyetherdiamin kann die Polyethereinheit beispielsweise auf 1.2-Ethandiol, 1.2-Propandiol, 1.3-Propandiol, 1.4-Butandiol oder 1.3-Butandiol basieren. Die Polyethereinheit kann auch gemischt aufgebaut sein, etwa mit statistischer oder blockweiser Verteilung der von den Diolen herrührenden Einheiten. Das Gewichtsmittel der Molmasse der Polyetherdiole bzw. Polyetherdiamine liegt bei 200 bis 5000 g/mol und vorzugsweise bei 400 bis 3000 g/mol; ihr Anteil am Polyetheresteramid bzw. Polyetheramid beträgt bevorzugt 4 bis 60 Gew.-% und besonders bevorzugt 10 bis 50 Gew.-%. Geeignete Polyetherdiamine sind durch Konversion der entsprechenden Polyetherdiole durch reduktive Aminierung oder Kupplung an Acrylnitril mit nachfolgender Hydrierung zugänglich; sie sind z. B. in Form der JEFFAMIN^{®} D- oder ED-Typen oder der ELASTAMINE^{®}-Typen bei der Huntsman Corp. oder in Form der Polyetheramin D-Reihe bei der BASF SE kommerziell erhältlich. In geringeren Mengen kann auch ein Polyethertriamin mit verwendet werden, z. B. ein JEFFAMIN^{®} T-Typ, falls ein verzweigtes Polyetheramid eingesetzt werden soll. Vorzugsweise setzt man Polyetherdiamine bzw. Polyethertriamine ein, die pro Ethersauerstoffatom im Mittel mindestens 2,3 Kohlenstoffatome in der Kette enthalten. Erfindungsgemäß sind Polyetheramide wegen der besseren Hydrolysebeständigkeit bevorzugt.

Die Formmasse der Schicht gemäß a) kann entweder eines der obengenannten Polyamide oder mehrere als Gemisch enthalten. Weiterhin können bis zu 40 Gew.-%, bezogen auf den gesamten Polymeranteil der Formmasse, andere Thermoplaste enthalten sein, beispielsweise schlagzähmachende Kautschuke. Eventuell enthaltene Kautschuke enthalten vorzugsweise, dem Stand der Technik entsprechend, funktionelle Gruppen, mit denen eine Verträglichkeit mit der Polyamidmatrix erhalten wird. Darüber hinaus können die für Polyamide üblichen Hilfs- und Zusatzstoffe enthalten sein, insbesondere Licht- und/oder Wärmestabilisatoren. Der Licht reflektierende Füllstoff kann jeder Füllstoff sein, der ein Reflektionsvermögen aufweist, das höher ist als das Reflektionsvermögen des Thermoplastanteils der Schicht gemäß a); er ist insbesondere Titandioxid (WO 2011066595).

Die Formmasse der Schicht gemäß b) kann als Thermoplast beispielsweise Polyamid, Polyolefin und/oder Polyester enthalten. Darüber hinaus können übliche Hilfs- und Zusatzstoffe enthalten sein, insbesondere Licht- und/oder Wärmestabilisatoren, Licht reflektierende Füllstoffe wie beispielsweise Titandioxid sowie verstärkende Füllstoffe wie beispielsweise Glasfasern, Wollastonit oder Glimmer.

Für die Formmasse der Schicht gemäß c) gilt das Gleiche wie für die Formmasse der Schicht gemäß a) sowie hinsichtlich Füllstoffen das Gleiche wie für die Formmasse der Schicht gemäß b). Zusätzlich kann die Formmasse der Schicht gemäß c) eingefärbt sein und/oder ein Mattierungsmittel aufweisen.

Die einzelnen Folienschichten weisen bei der dreischichtigen Ausführungsform in der Regel folgende Dicken auf:
- Schichten gemäß a) und c): 15 bis 100 µm und vorzugsweise 25 bis 50 µm;
- Schicht gemäß b): 100 bis 500 µm und vorzugsweise 150 bis 400 µm.

Bei der zweischichtigen Ausführungsform sind die Schichtdicken in der Regel folgendermaßen:
- Schicht gemäß a): 15 bis100 µm und vorzugsweise 25 bis 50 µm;
- Schicht gemäß c): 100 bis 500 µm und vorzugsweise 150 bis 400 µm.

Eventuell zwischen den Schichten gemäß a) und b) und/oder den Schichten gemäß b) und c) vorhandene Haftvermittlerschichten sind in der Regel 3 bis 40 µm und vorzugsweise 5 bis 25 µm dick.

Die erfindungsgemäß verwendete Mehrschichtfolie kann nach allen Methoden des Standes der Technik hergestellt werden, beispielsweise durch Coextrusion oder Laminieren.

Gegenstand der Erfindung ist auch die Verwendung der anspruchsgemäßen Folie als Rückabdeckung eines photovoltaischen Moduls. Hierzu wird die Schicht gemäß a) mit der Siegelschicht, in die die Solarzelle eingebettet ist, beispielsweise durch Laminieren oder Kleben verbunden. Wegen des Anteils an Polyamid bzw. Polyamidelastomer in der Schicht gemäß a) wird beim Laminieren eine gute Haftung zur Siegelschicht erhalten. Als Siegelschicht kann jedes gemäß dem Stand der Technik gebräuchliche Material verwendet werden.

Gegenstand der Erfindung ist darüber hinaus ein photovoltaisches Modul, das die anspruchsgemäße Mehrschichtfolie als Rückabdeckung enthält, wobei die Schicht gemäß a) mit der Siegelschicht, in die die Solarzelle eingebettet ist, verbunden ist.

Die Erfindung wird nachfolgend beispielhaft erläutert. Hierzu wurden folgende Formmassen hergestellt; bei "Teilen" handelt es sich immer um Gewichtsteile:

### Compound 1 für Außenschichten:

79,25 Teile VESTAMID^{®} L1901 nf (PA12), 0,5 Teile IRGANOX^{®} 1098 (ein sterisch gehindertes phenolisches Antioxidans), 0,2 Teile TINUVIN^{®} 312 (UV-Absorber) und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 2 für Außenschichten:

71,75 Teile VESTAMID^{®} L1901 nf, 7,5 Teile eines Polyetheresteramids (hergestellt aus 63,796 Gew.-% Laurinlactam, 6,645 Gew.-% Dodecandisäure, 29,492 Gew.-% PTHF 1000 und 0,067 Gew.-% unterphosphoriger Säure 50%ig), 0,5 Teile IRGANOX^{®} 1098, 0,2 Teile TINUVIN^{®} 312 und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 3 für Außenschichten:

64,25 Teile VESTAMID® L1901 nf, 15 Teile des gleichen Polyetheresteramids wie im Compound 2, 0,5 Teile IRGANOX^{®} 1098, 0,2 Teile TINUVIN^{®} 312 und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 4 für Mittelschicht:

50,6 Teile VESTAMID^{®} L1901, 26 Teile MOPLEN HP552L (Homopolypropylen, Extrusionstyp), 20 Teile Kaolin TEC 110, 3 Teile KRATON^{®} FG1901 (ein mit Maleinsäureanhydrid modifiziertes Styrol-Ethylen/Butylen-Blockcopolymer) und 0,4 Teile IRGANOX^{®} 1098 wurden mit Hilfe eines Zweiwellenextruders (Coperion Werner & Pfleiderer ZSK 25 WLE, 36 L/D) bei einer Zylindertemperatur von 200 °C gemischt. Der Strang wurde mit Hilfe eines Wasserbads gekühlt und geschnitten; das Granulat wurde anschließend 12 Stunden bei 80 °C im Umluftofen getrocknet.

### Extrusion dreischichtiger Folien:

Mit einer Mehrschichtfolienanlage der Fa. Collin (Breitschlitzdüse 300 mm, Spalt 0-6 mm, Co-Extrusionsfeedblock für 3-schichtige bzw. 5-schichtige Folien) wurden bei einer Verarbeitungstemperatur von ca. 230 °C dreischichtige Folien hergestellt. Die Mittelschicht wurde auf 250 µm eingestellt, die Außenschichten jeweils auf 50 µm. Die Ergebnisse sind in der Tabelle 1 dargestellt.

**Tabelle 1: Beispiele**

| | Schichtaufbau | Reflektivität bei 440 mm [%] |
|---|---|---|
| Vergleichsbeispiel | Compound 1/Compound 4/Compound 1 | 89,9 |
| Beispiel 1 | Compound 2/Compound 4/Compound 2 | 91,5 |
| Beispiel 2 | Compound 3/Compound 4/Compound 3 | 92,2 |

In der erfindungsgemäß verbesserten Reflektivität äußert sich die verbesserte Pigmentdispergierung.

## Patentansprüche

1. Folie, die folgende Schichten enthält:
a) Eine erste Außenschicht aus einer Formmasse, die
I. einen Polyamidanteil von mindestens 35 Gew.-% sowie
II. einen Licht reflektierenden Füllstoffanteil von 1 bis 65 Gew.-% enthält, sowie
c) eine zweite Außenschicht aus einer Formmasse, die
I. einen Polyamidanteil von mindestens 35 Gew.-% und
II. einen Füllstoffanteil von 1 bis 65 Gew.-% besitzt,
wobei die Prozentangaben jeweils auf die gesamte Formmasse bezogen sind, **dadurch gekennzeichnet,**
**dass** in der Formmasse der Schicht gemäß a) und/oder in der Formmasse der Schicht gemäß c) ein Polyamidelastomer, ausgewählt aus Polyetheresteramid und Polyetheramid, als Polyamidkomponente eingesetzt wird derart, dass die Formmasse der Schicht gemäß a) und/oder die Formmasse der Schicht gemäß c) 1 bis 25 Gew.-% an Polyamidelastomer enthält.

2. Folie gemäß Anspruch 1,
**dadurch gekennzeichnet,**
**dass** die Formmasse der Schicht gemäß a) und/oder die Formmasse der Schicht gemäß c) 2 bis 20 Gew.-% an Polyamidelastomer enthält.

3. Folie gemäß einem der vorhergehenden Ansprüche,
**dadurch gekennzeichnet,**
**dass** das Polyamidelastomer ein Polyetheramid ist.

4. Folie gemäß einem der vorhergehenden Ansprüche,
**dadurch gekennzeichnet,**
**dass** sich zwischen den Schichten gemäß a) und c) folgende Schicht befindet: b) eine Mittelschicht aus einer thermoplastischen Formmasse.

5. Folie gemäß Anspruch 4,
**dadurch gekennzeichnet,**
**dass** sich zwischen den Schichten gemäß a) und b) und/oder zwischen den Schichten gemäß b) und c) eine Haftvermittlerschicht befindet.

6. Folie gemäß einem der Ansprüche 1 bis 3,
**dadurch gekennzeichnet,**
**dass** die Schichten gemäß a) und c) direkt aufeinanderfolgen.

7. Folie gemäß einem der Ansprüche 4 und 5,
**dadurch gekennzeichnet, dass**
- die Schichten gemäß a) und c) eine Dicke von 15 bis 100 µm und
- die Schicht gemäß b) eine Dicke von 100 bis 500 µm besitzt.

8. Folie gemäß einem der Ansprüche 5 und 7,
**dadurch gekennzeichnet,**
**dass** die Haftvermittlerschicht bzw. die Haftvermittlerschichten jeweils 3 bis 40 µm dick sind.

9. Folie gemäß Anspruch 6,
**dadurch gekennzeichnet**,
- die Schicht gemäß a) eine Dicke von 15 bis 100 µm und
- die Schicht gemäß c) eine Dicke von 100 bis 500 µ besitzt.

10. Folie gemäß einem der vorhergehenden Ansprüche,
**dadurch gekennzeichnet,**
**dass** der Licht reflektierende Füllstoff Titandioxid ist.

11. Verwendung einer Folie gemäß einem der vorhergehenden Ansprüche als Rückabdeckung eines photovoltaischen Moduls, wobei die Schicht gemäß a) mit der Siegelschicht, in die die Solarzelle eingebettet ist, verbunden wird.

12. Photovoltaisches Modul, das die Folie gemäß einem der Ansprüche 1 bis 10 als Rückabdeckung enthält, wobei die Schicht gemäß a) mit der Siegelschicht, in die die Solarzelle eingebettet ist, verbunden ist.

## Claims

1. Film comprising the following layers:
a) a first outer layer of a moulding composition comprising
I. a polyamide content of at least 35% by weight and
II. a light-reflecting filler content of 1 to 65% by weight, and
c) a second outer layer of a moulding composition having
I. a polyamide content of at least 35% by weight and
II. a filler content of 1 to 65% by weight, where the percentages are each based on the overall moulding composition,
**characterized in that**
a polyamide elastomer selected from polyetheresteramide and polyetheramide is used as the polyamide component in the moulding composition of the layer according to a) and/or in the moulding composition of the layer according to c) such that the moulding composition of the layer according to a) and/or the moulding composition of the layer according to c) contains 1 to 25% by weight of polyamide elastomer.

2. Film according to Claim 1,
**characterized in that**
the moulding composition of the layer according to a) and/or the moulding composition of the layer according to c) contains 2 to 20% by weight of polyamide elastomer.

3. Film according to either of the preceding claims, **characterized in that**
the polyamide elastomer is a polyetheramide.

4. Film according to any of the preceding claims,
**characterized in that**
the following layer is present between the layers according to a) and c):
b) a middle layer of a thermoplastic moulding composition.

5. Film according to Claim 4,
**characterized in that**
an adhesion promoter layer is present between the layers according to a) and b) and/or between the layers according to b) and c).

6. Film according to any of Claims 1 to 3,
**characterized in that**
the layers according to a) and c) are in direct succession.

7. Film according to either of Claims 4 and 5,
**characterized in that**
- the layers according to a) and c) have a thickness of 15 to 100 µm and
- the layer according to b) has a thickness of 100 to 500 µm.

8. Film according to either of Claims 5 and 7,
**characterized in that**
the adhesion promoter layer is/the adhesion promoter layers are each 3 to 40 µm thick.

9. Film according to Claim 6,
**characterized in that**
- the layer according to a) has a thickness of 15 to 100 µm and
- the layer according to c) a thickness of 100 to 500 µm.

10. Film according to any of the preceding claims,
**characterized in that**
the light-reflecting filler is titanium dioxide.

11. Use of a film according to any of the preceding claims as a back cover of a photovoltaic module, with bonding of the layer according to a) to the sealing layer into which the solar cell has been embedded.

12. Photovoltaic module comprising the film according to any of claims 1 to 10 as a back cover, with bonding of the layer according to a) to the sealing layer into which the solar cell has been embedded.

## Revendications

1. Feuille contenant les couches suivante :
a) une première couche externe en une masse de moulage qui contient
I. une proportion de polyamide d'au moins 35% en poids ainsi que
II. une proportion de charge réfléchissant la lumière de 1 à 65% en poids ainsi que
c) une deuxième couche externe en une masse de moulage qui contient
I. une proportion de polyamide d'au moins 35% en poids et
II. une proportion de charge de 1 à 65% en poids, les indications en pour cent se rapportant à chaque fois à la masse de moulage totale,
**caractérisée en ce qu'**un élastomère de polyamide, choisi parmi un polyétheresteramide et un polyétheramide, est utilisé comme composant polyamide dans la masse de moulage de la couche selon a) et/ou dans la masse de moulage de la couche selon c), de manière telle que la masse de moulage de la couche selon a) et/ou la masse de moulage de la couche selon c) contient 1 à 25% en poids d'élastomère de polyamide.

2. Feuille selon la revendication 1, **caractérisée en ce que** la masse de moulage de la couche selon a) et/ou la masse de moulage de la couche selon c) contient 2 à 20% en poids d'élastomère de polyamide.

3. Feuille selon l'une quelconque des revendications précédentes, **caractérisée en ce que** l'élastomère de polyamide est un polyétheramide.

4. Feuille selon l'une quelconque des revendications précédentes, **caractérisée en ce que** la couche suivante se trouve entre les couches selon a) et c) :
b) une couche centrale en masse de moulage thermoplastique.

5. Feuille selon la revendication 4, **caractérisée en ce qu'**une couche de promoteur d'adhérence se trouve entre les couches selon a) et b) et/ou entre les couches selon b) et c).

6. Feuille selon l'une quelconque des revendications 1 à 3, **caractérisée en ce que** les couches selon a) et c) se suivent directement.

7. Feuille selon l'une quelconque des revendications 4 et 5, **caractérisée en ce que**
- les couches selon a) et c) présentent une épaisseur de 15 à 100 µm, et
- la couche selon b) présente une épaisseur de 100 à 500 µm.

8. Feuille selon l'une quelconque des revendications 5 et 7, **caractérisée en ce que** la couche ou les couches de promoteur d'adhérence présentent à chaque fois une épaisseur de 3 à 40 µm.

9. Feuille selon la revendication 6, **caractérisée en ce que**
- la couche selon a) présente une épaisseur de 15 à 100 µm et
- la couche selon c) présente une épaisseur de 100 à 500 µm.

10. Feuille selon l'une quelconque des revendications précédentes, **caractérisée en ce que** la charge réfléchissant la lumière est le dioxyde de titane.

11. Utilisation d'une feuille selon l'une quelconque des revendications précédentes comme recouvrement arrière d'un module photovoltaïque, la couche selon a) étant assemblée avec la couche de scellement dans laquelle la cellule solaire est incorporée.

12. Module photovoltaïque qui contient la feuille selon l'une quelconque des revendications 1 à 10 comme recouvrement arrière, la couche selon a) étant assemblée avec la couche de scellement dans laquelle la cellule solaire est incorporée.
